# EUROPEAN PATENT SPECIFICATION

(11) **EP 1 399 294 B1**
(45) Date of publication and mention of the grant of the patent: **21.12.2005**
(21) Application number: 01950481.0
(22) Date of filing: 26.06.2001
(51) Int. Cl.: B24B 37/04, B24B 49/14, H01L 21/66

(54) **END POINT DETECTION SYSTEM FOR CHEMICAL MECHANICAL POLISHING APPLICATIONS**
SYSTEM ZUR ENDPUNKTBESTIMMUNG BEIM CHEMISCH-MECHANISCHEN POLIEREN
SYSTEME DE DETECTION DE POINT D'EXTREMITE POUR APPLICATIONS DE POLISSAGE MECANO-CHIMIQUE

(43) Date of publication of application: 24.03.2004
(73) Proprietor: LAM RESEARCH CORPORATION, Fremont, CA 94568 (US)
(72) Inventor: MIKHAYLICH, Katrina, A., San Jose, CA 95131 (US); RAVKIN, Mike, Sunnyvale, CA 94087 (US); GOTKIS, Yehiel, Fremont, CA 94538 (US)
(74) Representative: Thomson, Paul Anthony
(86) International application number: PCT/US2001/020283
(87) International publication number: WO 2003/002301

(56) References cited:
- EP-A- 0 616 362
- JP-A- 9 148 281
- JP-A- 2000 340 538
- US-A- 5 597 442
- US-A- 6 007 408
- US-A- 6 153 116

## Description

### BACKGROUND OF THE INVENTION

### 1. Field of the Invention

The present invention relates generally to the chemical mechanical polishing (CMP) of semiconductor wafers, and more particularly, to techniques for polishing end-point detection.

### 2. Description of the Related Art

In the fabrication of semiconductor devices, there is a need to perform CMP operations, including polishing, buffing and wafer cleaning. Typically, integrated circuit devices are in the form of multi-level structures. At the substrate level, transistor devices having diffusion regions are formed. In subsequent levels, interconnect metallization lines are patterned and electrically connected to the transistor devices to define the desired functional device. As is well known, patterned conductive layers are insulated from other conductive layers by dielectric materials, such as silicon dioxide. At each metallization level there is a need to planarize metal or associated dielectric material. Without planarization, fabrication of additional metallization layers becomes substantially more difficult due to the higher variations in the surface topography. In other applications, metallization line patterns are formed in the dielectric material, and then metal CMP operations are performed to remove excess metallization, e.g., such as copper.

In the prior art, CMP systems typically implement belt, orbital, or brush stations in which belts, pads, or brushes are used to scrub, buff, and polish a wafer. Slurry is used to facilitate and enhance the CMP operation. Slurry is most usually introduced onto a moving preparation surface, *e.g*., belt, pad, brush, and the like, and distributed over the preparation surface as well as the surface of the semiconductor wafer being buffed, polished, or otherwise prepared by the CMP process. The distribution is generally accomplished by a combination of the movement of the preparation surface, the movement of the semiconductor wafer and the friction created between the semiconductor wafer and the preparation surface.

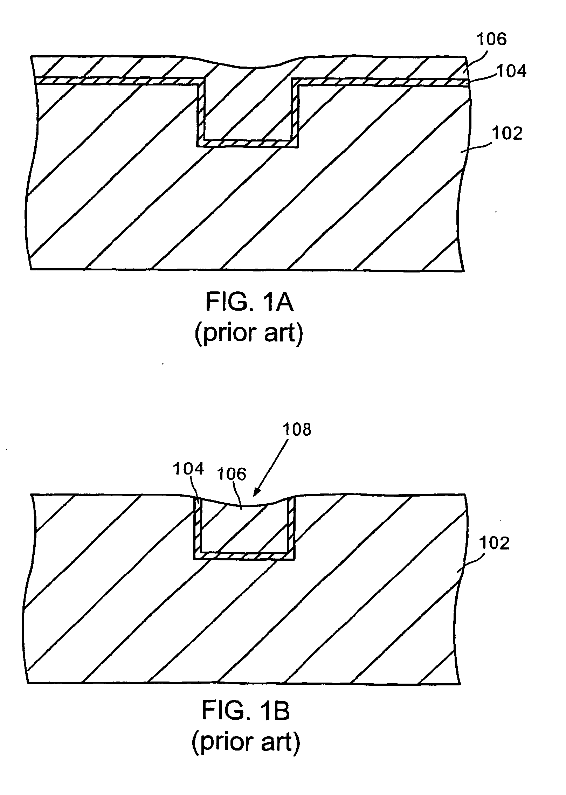

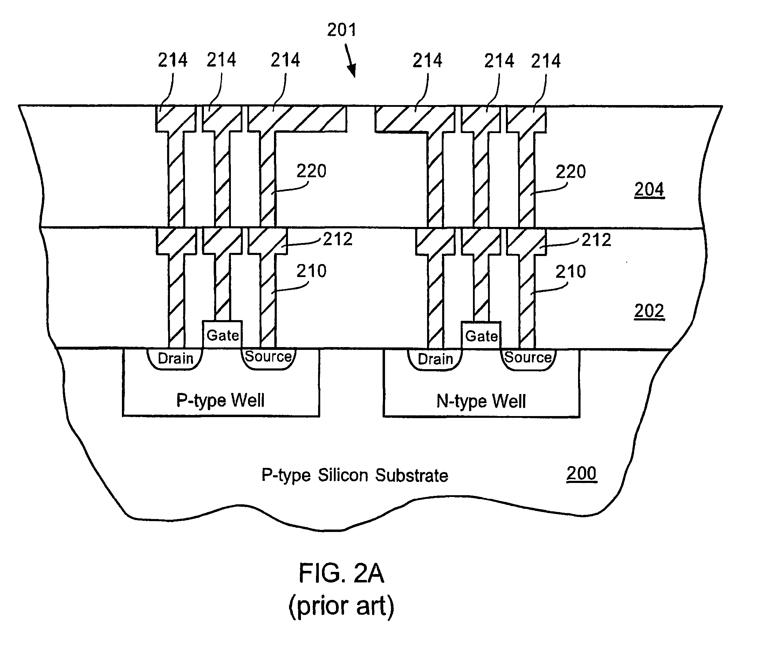

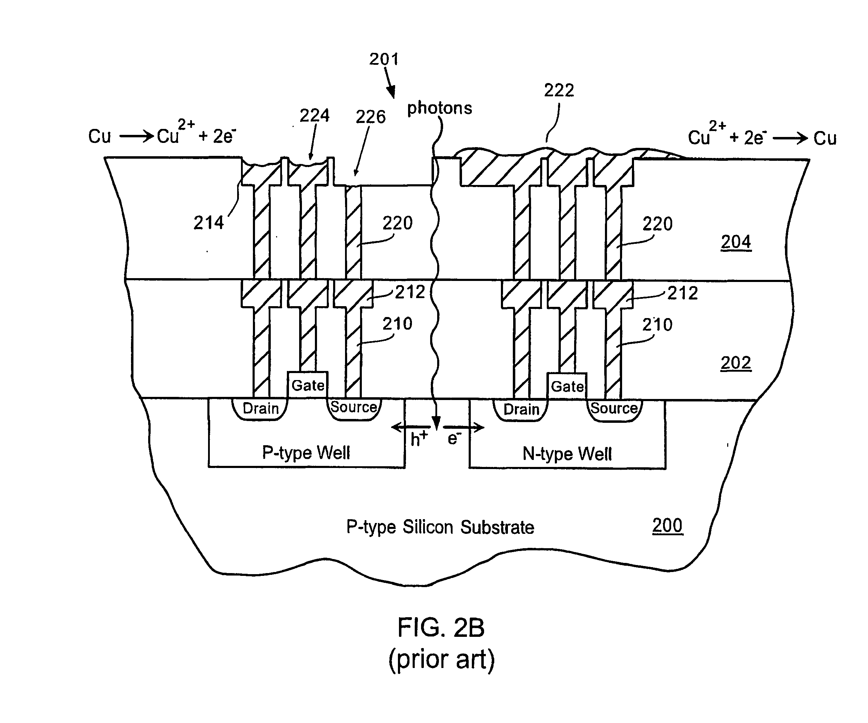

Figure 1A shows a cross sectional view of a dielectric layer 102 undergoing a fabrication process that is common in constructing damascene and dual damascene interconnect metallization lines. The dielectric layer 102 has a diffusion barrier layer 104 deposited over the etch-patterned surface of the dielectric layer 102. The diffusion barrier layer, as is well known, is typically titanium nitride (TiN), tantalum (Ta), tantalum nitride (TaN) or a combination of tantalum nitride (TaN) and tantalum (Ta). Once the diffusion barrier layer 104 has been deposited to the desired thickness, a copper layer 104 is formed over the diffusion barrier layer in a way that fills the etched features in the dielectric layer 102. Some excessive diffusion barrier and metallization material is also inevitably deposited over the field areas. In order to remove these overburden materials and to define the desired interconnect metallization lines and associated vias (not shown), a chemical mechanical planarization (CMP) operation is performed.

As mentioned above, the CMP operation is designed to remove the top metallization material from over the dielectric layer 102. For instance, as shown in Figure 1B, the overburden portion of the copper layer 106 and the diffusion barrier layer 104 have been removed. As is common in CMP operations, the CMP operation must continue until all of the overburden metallization and diffusion barrier material 104 is removed from over the dielectric layer 102. However, in order to ensure that all the diffusion barrier layer 104 is removed from over the dielectric layer 102, there needs to be a way of monitoring the process state and the state of the wafer surface during its CMP processing. This is commonly referred to as end-point detection. In multi-step CMP operations there is a need to ascertain multiple end-points (e.g., such as to ensure that Cu is removed from over the diffusion barrier layer; and to ensure that the diffusion barrier layer is removed from over the dielectric layer). Thus, end-point detection techniques are used to ensure that all of the desired overburden material is removed. A common problem with current end-point detection techniques is that some degree of over-etching is required to ensure that all of the conductive material (*e*.*g*., metallization material or diffusion barrier layer 104) is removed from over the dielectric layer 102 to prevent inadvertent electrical interconnection between metallization lines. A side effect of improper end-point detection or over-polishing is that dishing 108 occurs over the metallization layer that is desired to remain within the dielectric layer 102. The dishing effect essentially removes more metallization material than desired and leaves a dish-like feature over the metallization lines. Dishing is known to impact the performance of the interconnect metallization lines in a negative way, and too much dishing can cause a desired integrated circuit to fail for its intended purpose.

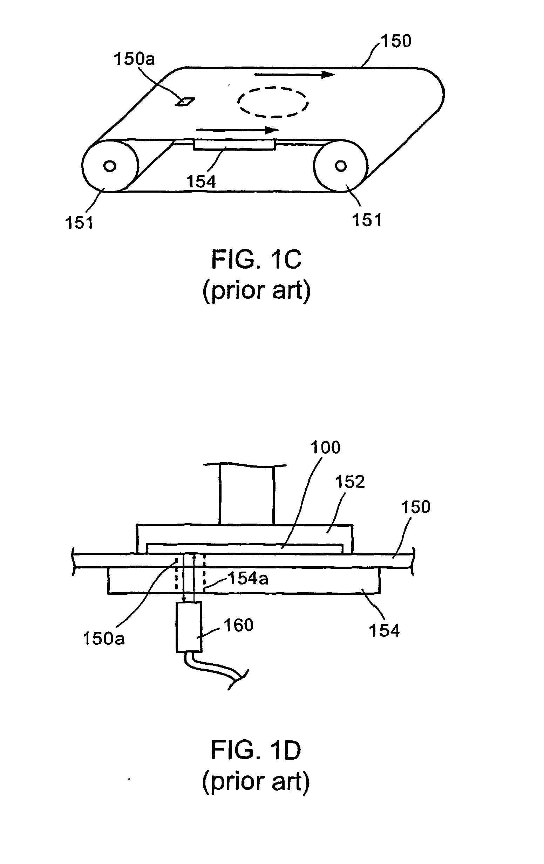

Figure 1C shows a prior art belt CMP system in which a pad 150 is designed to rotate around rollers 151. As is common in belt CMP systems, a platen 154 is positioned under the pad 150 to provide a surface onto which a wafer will be applied using a carrier 152 as shown in Figure 1B. One way of performing end-point detection is to use an optical detector 160 in which light is applied through the platen 154, through the pad 150 and onto the surface of the wafer 100 being polished. In order to accomplish optical end-point detection, a pad slot 150a is formed into the pad 150. In some embodiments, the pad 150 may include a number of pad slots 150a strategically placed in different locations of the pad 150. Typically, the pad slots 150a are designed small enough to minimize the impact on the polishing operation. In addition to the pad slot 150a, a platen slot 154a is defined in the platen 154. The platen slot 154a is designed to allow the optical beam to be passed through the platen 154, through the pad 150, and onto the desired surface of the wafer 100 during polishing.

By using the optical detector 160, it is possible to ascertain a level of removal of certain films from the wafer surface. This detection technique is designed to measure the thickness of the film by inspecting the interference patterns received by the optical detector 160. Although optical end-point detection is suitable for some applications, optical end-point detection may not be adequate in cases where end-point detection is desired for different regions or zones of the semiconductor wafer 100. In order to inspect different zones of the wafer 100, it is necessary to define several pad slots 150a as well as several platen slots 154a. As more slots are defined in the pad 150 and the platen 154, there may be a greater detrimental impact upon the polishing being performed on the wafer 100. That is, the surface of the pad 150 will be altered due to the number of slots formed into the pad 150 as well as complicating the design of the platen 154.

Additionally, conventional platens 154 are designed to strategically apply certain degrees of back pressure to the pad 150 to enable precision removal of the layers from the wafer 100. As more platen slots 154a are defined into the platen 154, it will be more difficult to design and implement pressure applying platens 154. Accordingly, optical end-point detection is generally complex to integrate into a belt CMP system and also poses problems in the complete detection of end-point throughout different zones or regions of a wafer without impacting the CMP system's ability to precision polish layers of the wafer.

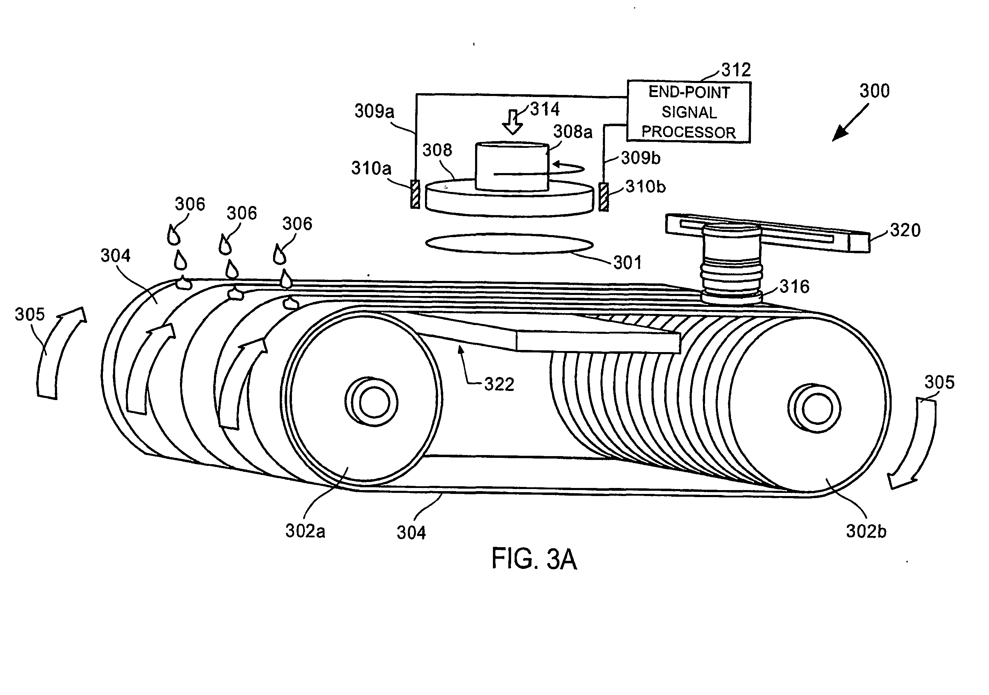

Figure 2A shows a partial cross-sectional view of an exemplary semiconductor chip 201 after the top layer has undergone a copper CMP process. Using standard impurity implantation, photolithography, and etching techniques, P-type transistors and N-type transistors are fabricated into the P-type silicon substrate 200. As shown, each transistor has a gate, source, and drain, which are fabricated into appropriate wells. The pattern of alternating P-type transistors and N-type transistors creates a complementary metal dielectric semiconductor (CMOS) device.

A first dielectric layer 202 is fabricated over the transistors and substrate 200. Conventional photolithography, etching, and deposition techniques are used to create tungsten plugs 210 and copper lines 212. The tungsten plugs 210 provide electrical connections between the copper lines 212 and the active features on the transistors. A second dielectric layer 204 may be fabricated over the first dielectric layer 202 and copper lines 212. Conventional photolithography, etching, and deposition techniques are used to create copper vias 220 and copper lines 214 in the second dielectric layer 204. The copper vias 220 provide electrical connections between the copper lines 214 in the second layer and the copper lines 212 or the tungsten plugs 210 in the first layer.

The wafer then typically undergoes a copper CMP process to planarize the surface of the wafer as described with reference to Figures 1A-1D, leaving an approximately flat surface (with possible dishing, not shown here, but illustrated with reference to Figure 1B). After the copper CMP process, the wafer is cleaned in a wafer cleaning system.

Figure 2B shows the partial cross-sectional view after the wafer has undergone optical end-point detection as discussed with reference to Figures 1C and 1D. As shown, the copper lines 214 on the top layer have been subjected to photo-corrosion during the detection process. The photo-corrosion is believed to be partially caused by light photons emitted by the optical detector and reach the P/N junctions, which can act as solar cells. Unfortunately, this amount of light, which is generally normal for optical detection can cause a catastrophic corrosion effect.

In this cross-sectional example, the copper lines, copper vias, or tungsten plugs are electrically connected to different parts of the P/N junction. The slurry chemicals and/or chemical solutions applied to the wafer surface, can include electrolytes, which have the effect of closing an electrical circuit as electrons *e*^{*-*} and holes *h*^{*+*} are transferred across the P/N junctions. The electron/hole pairs photo-generated in the junction are separated by the electrical field. The introduced carriers induce a potential difference between the two sides of the junction. This potential difference increases with light intensity. Accordingly, at the electrode connected to the P-side of the junction, the copper is corroded: Cu → Cu²⁺ + 2*e*⁻. The produced soluble ionic species can diffuse to the other electrode, where the reduction can occur: Cu²⁺ + *2e*⁻ → Cu. Note that the general corrosion formula for any metal is *M* → *M*^{*n+*} + *ne*^{*-*}*,* and the general reduction formula for any metal is M^{*n+*} + *ne*^{*-*} *→ M.* For more information on photo-corrosion effects, reference can be made to an article by A. Beverina et al., "Photo-Corrosion Effects During Cu Interconnection Cleanings," to be published in the *196*^{*th*} *ECS Meeting,* Honolulu, Hawaii (October 1999).

Unfortunately, this type of photo-corrosion displaces the copper lines and destroys the intended physical topography of the copper features, as shown in Figure 2B. At some locations on the wafer surface over the P-type transistors, the photo-corrosion effect may cause corroded copper lines 224 or completely dissolved copper lines 226. In other words, the photo-corrosion may completely corrode the copper line such that the line no longer exists. On the other hand, over the N-type transistors, the photo-corrosion effect may cause copper deposit 222 to be formed. This distorted topography, including the corrosion of the copper lines, may cause device defects that render the entire chip inoperable. One defective device means the entire chip must be discarded, thus, decreasing yield and drastically increasing the cost of the fabrication process. This effect, however, will generally occur over the entire wafer, thus destroying many of the chips on the wafer. This, of course, increases the cost of fabrication.

A chemical mechanical polishing system and method in accordance with the preambles of claims 1 and 11, is known from EP 0 616 362 A2. The known polishing apparatus comprises an infrared light temperature sensor for detecting a surface temperature of the polishing pad and a processor for processing a signal for indicating a surface temperature of the pad and a process end point detector.

In view of the foregoing, there is a need for CMP end-point detection systems that do not implement optical detectors and enable precision end-point detection to prevent dishing and avoid the need to perform excessive over-polishing.

### SUMMARY OF THE INVENTION

Broadly speaking, the present invention fills these needs by providing end-point detection systems and methods to be used in the chemical mechanical polishing of substrate surface layers as defined by claims 1 and 11, respectively. Preferred additional features are specified in dependent claims 2 to 10 and 11 to 19. For example, the present invention can be used with linear belt pad systems, rotary pad systems, as well as orbital pad systems.

The present invention will become apparent from the following detailed description, taken in conjunction with the accompanying drawings, illustrating by way of example the principles of the present invention.

### BRIEF DESCRIPTION OF THE DRAWINGS

The present invention will be readily understood by the following detailed description in conjunction with the accompanying drawings, in which like reference numerals designate like structural elements.
Figures 1A and 1B show a cross sectional view of a dielectric layer undergoing a fabrication process that is common in constructing damascene and dual damascene interconnect metallization lines and structures.
Figures 1C and 1D shows a prior art belt CMP system in which a pad is designed to rotate around rollers and an optical end-point detection system is used.
Figure 2A shows a cross-sectional view of a conventional semiconductor chip after the top layer has undergone a copper CMP process.
Figure 2B shows a cross-sectional view of the conventional semiconductor chip of Figure 2A after the wafer has undergone through photo-assisted corrosion due to, for example, optical end-point detection.
Figure 3A shows a CMP system including an end-point detection system, in accordance with one embodiment of the present invention.
Figure 3B shows a top view of a portion of a pad that is moving linearly.
Figure 3C illustrates a side view of a carrier applying a wafer to a pad.
Figure 3D is a more detailed view of Figure 3C.
Figure 4A shows a cross-sectional view of a dielectric layer, a diffusion barrier layer, and a copper layer, each of the copper layer and diffusion barrier layer being configured to be removed during a CMP operation that includes end-point detection, in accordance with one embodiment of the present invention.
Figures 4B and 4C provide a temperature differential versus time plot, in accordance with one embodiment of the present invention.
Figure 5A illustrates a top view diagram of another embodiment of the present invention in which a plurality of sensors 1 through 10 and a pair of reference sensors R are arrange around and proximate to a carrier (therefore, any number of pairs of sensors can be used depending upon the application).
Figure 5B illustrates a table having target temperature differentials for each zone of a wafer, in accordance with one embodiment of the present invention.
Figure 6 illustrates a schematic diagram of the sensors 1 through 10 shown in Figure 5A.

### DETAILED DESCRIPTION OF THE PREFERRED EMBODIMENTS

An invention for chemical mechanical polishing (CMP) end-point detection systems and methods for implementing such systems are disclosed. In the following description, numerous specific details are set forth in order to provide a thorough understanding of the present invention. It will be understood, however, to one skilled in the art, that the present invention may be practiced without some or all of these specific details. In other instances, well known process operations have not been described in detail in order not to unnecessarily obscure the present invention.

Figure 3A shows a CMP system 300 including an end-point detection system, in accordance with one embodiment of the present invention. The end-point detection system is designed to include sensors 310a and 310b positioned near a location that is proximate to a carrier 308. As is well known, the carrier 308 is designed to hold a wafer 301 and apply the wafer 301 to the surface of a pad 304. The pad 304 is designed to move in a pad motion direction 305 around rollers 302a and 302b. The pad 304 is generally provided with slurry 306 that assists in the chemical mechanical polishing of the wafer 301. In this embodiment, the CMP system 300 also includes a conditioning head 316 that is connected to a track 320. The conditioning head is designed to scrub the surface of the pad 304 either in an in-situ manner or an ex-situ manner. As is well known, the conditioning of the pad 304 is designed to re-condition the surface of the pad 304 to improve the performance of the polishing operations.

The sensors 310a and 310b are designed to be fixed over a location of the pad 304, while the carrier 308 rotates the wafer 301 over the surface of the pad 304. Accordingly, the sensors 310a and 310b will not rotate with the carrier 308, but will remain at a same approximate location over the platen 322. The sensors 310a and 310b are preferably temperature sensors which sense the temperature of the pad 304 during a CMP operation. The sensed temperature is then provided to sensing signals 309a and 309b which are communicated to an end-point signal processor 312. As shown, the carrier 308 also has a carrier positioner 308a which is designed to lower and raise the carrier 308 and associated wafer 301 over the pad 304 in the direction 314.

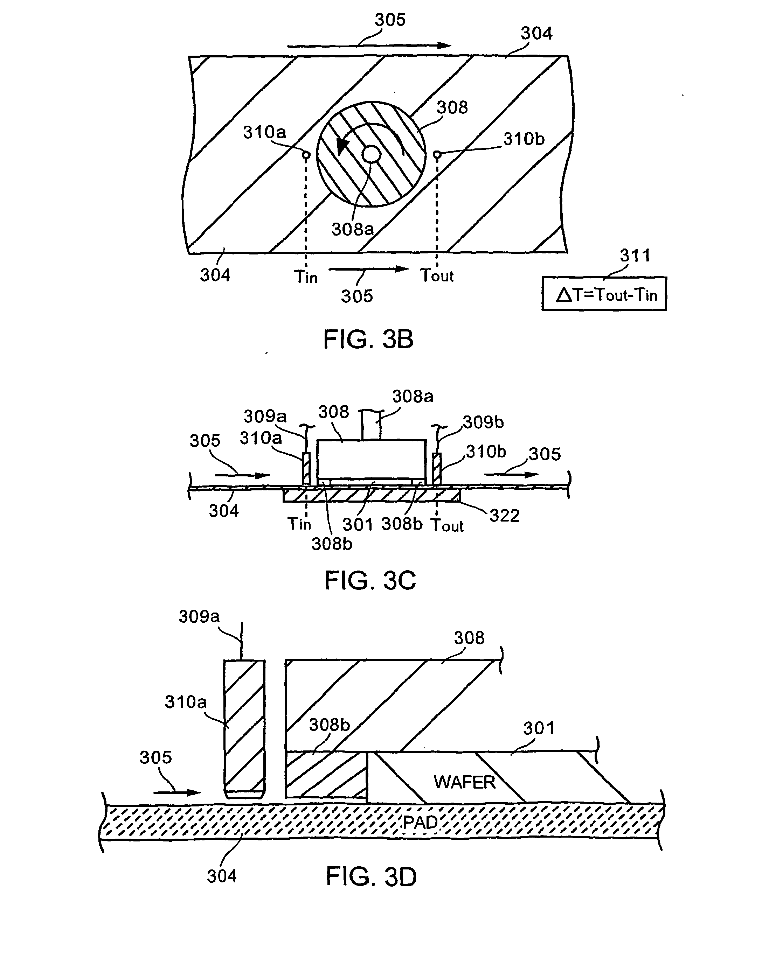

Figure 3B shows a top view of a portion of a pad 304 that is moving in the motion direction 305. As shown, the carrier 308 is lowered by the carrier positioner 308a onto the pad 304. The sensors 310a and 310b are also lowered toward the pad 304 as shown in Figures 3C and 3D. The sensors 310a and 310b, as described above, do not rotate with the carrier 308, but remain at the same relative position over the pad 304. Accordingly, the sensors 310a and 310b are designed to be fixed, however, may move in a vertical direction toward the pad 304 and away from the pad 304 synchronously with the carrier 308. Thus, when the carrier 308 is lowered toward the pad 304, the sensors 310a and 310b will also be lowered toward the surface of the pad 304. In another embodiment, the carrier 308 can move independently from the sensors 310a and 310b.

In a preferred embodiment of the present invention, the sensors 310a and 310b are designed to sense a temperature emanating from the pad 304. Because the wafer, during polishing, is in constant friction with the pad 304, the pad 304 will change in temperature from the time the pad 304 moves from the fixed position of sensor 310a and sensor 310b. Typically, the heat is absorbed by the wafer, the pad material, outgoing slurry and process by-products. This therefore produces differences in temperature that can be sensed. Thus, the sensed temperature for sensor 310a will be a temperature "in" (Tin) and the temperature sensed at sensor 310b will be a temperature "out" (Tout). A temperature differential (ΔT) will then be measured by subtracting Tin from Tout. The temperature differential is shown as an equation in box 311 of Figure 3B.

Figure 3C illustrates a side view of the carrier 308 applying the wafer 301 to the pad 304. As shown, the carrier 308 applies the wafer 301 that is held by a retaining ring 308b against the pad 304 over the platen 322. As the pad 304 moves in the motion direction 305, the sensor 310a will detect a temperature Tin that is communicated as a sensing signal 309a to the end-point signal processor 312. The sensor 310b is also configured to receive a temperature Tout and provide the sensed temperature over a sensing signal 309b to the end-point signal to processor 312. In one embodiment, the sensors 310 are preferably positioned proximately to the pad 304 such that the temperature can be sensed accurately enough and provided to the end-point signal processor 312. For example, the sensors are preferably adjusted such that they are between about 1 millimeter and about 250 millimeters from the surface of the pad 304 when the carrier 308 is applying the wafer 301 to the surface of the pad 304. The sensor 310a shown in Figure 3D, in a preferred embodiment, is positioned such that it is about 5 millimeters from the surface of the pad 304.

In this preferred embodiment, the sensors 310 are preferably infrared sensors that are configured to sense the temperature of the pad 304 as the pad moves linearly in the pad motion direction 305. One exemplary infrared temperature sensor is Model No. 39670-10, which is sold by Cole Parmer Instruments, Co. of Vernon Hills, IL. In another embodiment, the sensors 310 need not necessarily be directly adjacent to the carrier 308. For instance, the sensors can be spaced apart from the carrier 308 at a distance that is between about 1/8 of an inch and about 5 inches, and most preferably positioned at about ¼ inch from the side of the carrier 308. Preferably, the spacing is configured such that the sensors 310 do not interfere with the rotation of the carrier 308 since the sensors 310 are fixed relatively to the pad while the carrier 308 is configured to rotate the wafer 301 up against the pad surface 304.

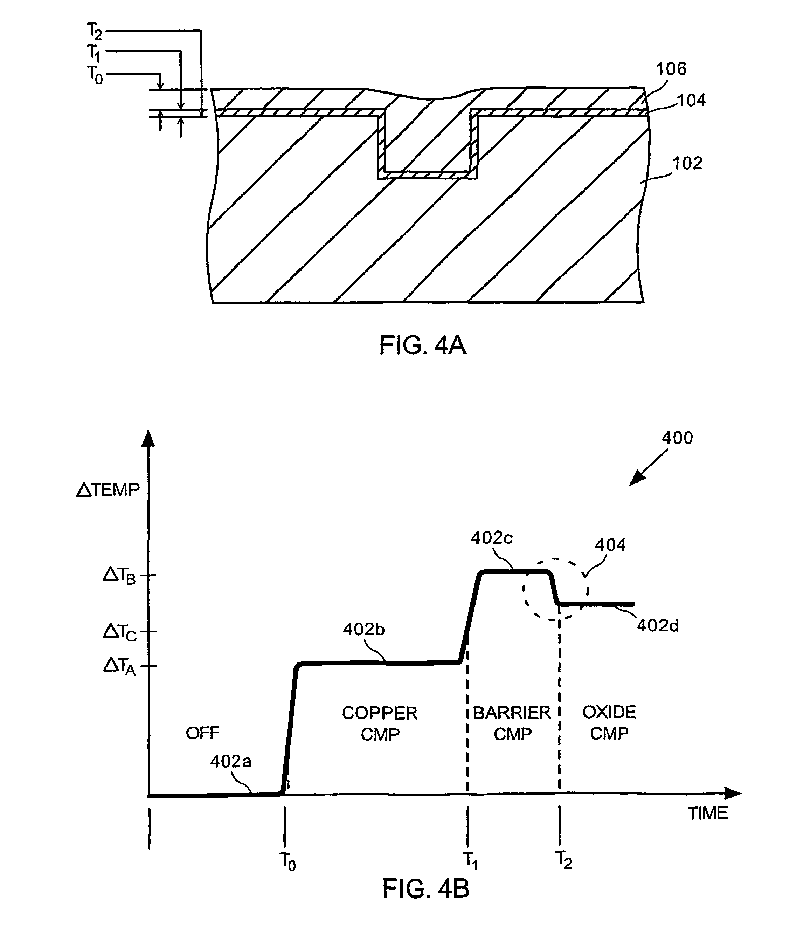

Figure 4A shows a cross-sectional view of the dielectric layer 102, the diffusion barrier layer 104, and the copper layer 106. The thicknesses of the diffusion barrier layer 104 and the copper layer 106 can vary from wafer-to-wafer and surface zone-to-surface zone throughout a particular wafer being polished. However, during a polishing operation, it will take an approximate amount of time to remove the desired amount of material from over the wafer 301. For instance, it will take up to about a time T₂ to remove the diffusion barrier layer 104, up to a time T₁ to remove the copper 104 down to the diffusion barrier layer 104 relative to a time T₀, which is when the polishing operation begins.

For illustration purposes, Figure 4B provides a temperature differential versus time plot 400. The temperature differential versus time plot 400 illustrates a temperature differential change over the pad 304 surface between the sensors 310a and 310b. For instance, at a time T₀, the temperature differential state 402a will be zero since the polishing operation has not yet begun. Once the polishing operation begins on the copper material, the temperature differential 402b will move up to a temperature differential ΔT_{A}. This temperature differential is an increase relative to the OFF position because the temperature of the pad 304 increases as the frictional stresses are received by the application of the wafer 301 to the pad 304.

The temperature differential ΔT_{A} also increases to a certain level based on the type of material being polished. Once the copper layer 106 is removed from over the structure of Figure 4A, the CMP operation will continue over the diffusion barrier layer 104. As the diffusion barrier layer material begins to be polished, the temperature differential will move from 402b to 402c. The temperature differential 402c is shown as ΔT_{B}. This is an increase in temperature differential due to the fact that the diffusion barrier layer 104 is a harder material than the copper layer 106. As soon as the diffusion barrier layer 104 is removed from over the dielectric layer 102, more dielectric material will begin to be polished thus causing another shift in the temperature differential at a time T₂.

At this point, the temperature differential 402d will be produced at ΔT_{C}. The shift between ΔT_{B} and ΔT_{C} will thus define a target end-point temperature differential change 404. This target end-point temperature differential change 404 will occur at about a time T₂. In order to ascertain the appropriate time to stop the polishing operation to ensure that the diffusion barrier layer 104 is adequately removed from over the dielectric layer 102, an examination of the transition between 402c and 402d is preferably made.

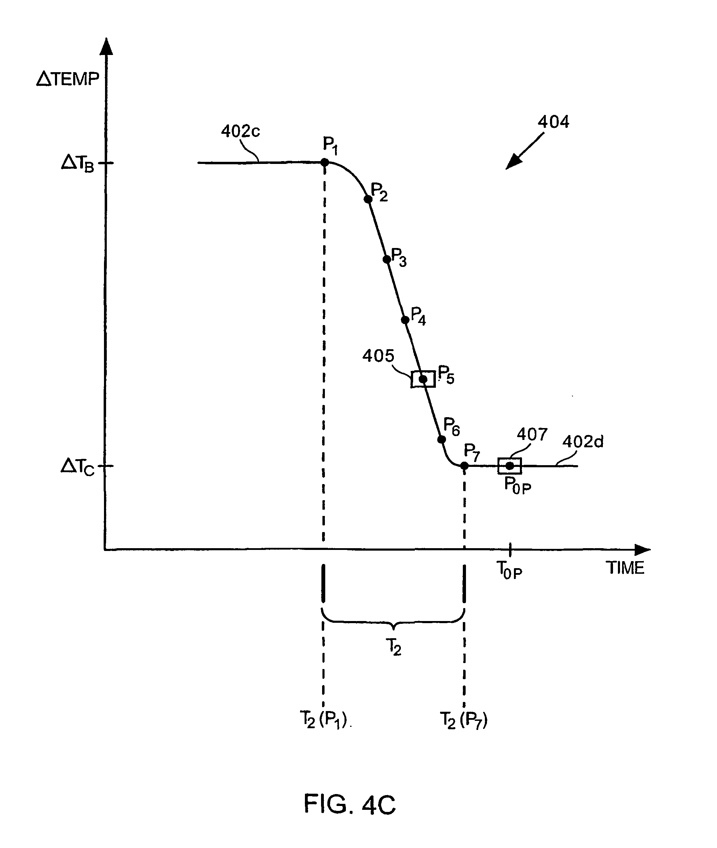

As shown in Figure 4C, the target end-point temperature differential change 404 is shown in magnification wherein tests were made at several points P₁, P₂, P₃, P₄, P₅, P₆, and P₇. These points span the temperature differential ΔT_{B} and ΔT_{C}. As shown, time T₂ actually spans between a time T₂ (P₁), and a time T₂(P₇). To ensure the best and most accurate end-point, it is necessary to ascertain at what time to stop within time T₂. The different points P₁ through P₇ are preferably analyzed by polishing several test wafers having the same materials and layer thicknesses. By examining the different layers being polished for different periods of time as well as the thicknesses of the associated layers, it is possible to ascertain a precision time at which to stop the polishing operation. For instance, the polishing operation may be stopped at a point P₅ 405 instead of a point P_{OP} 407, which defines an over-polish time. The over-polishing technique is typically used in the prior art when it is uncertain when the diffusion barrier layer or any other layer being polished has, in fact, been removed from over the base layer (*e.g*., dielectric layer).

However, by inspecting the transition between time differential 402c and time differential 402d, it is possible to ascertain the proper time to stop the polishing operation (thus detecting an exact or nearly exact end-point) within a window that avoids the aforementioned problems of dishing and other over-polishing damage than can occur to sensitive interconnect metallization lines or features.

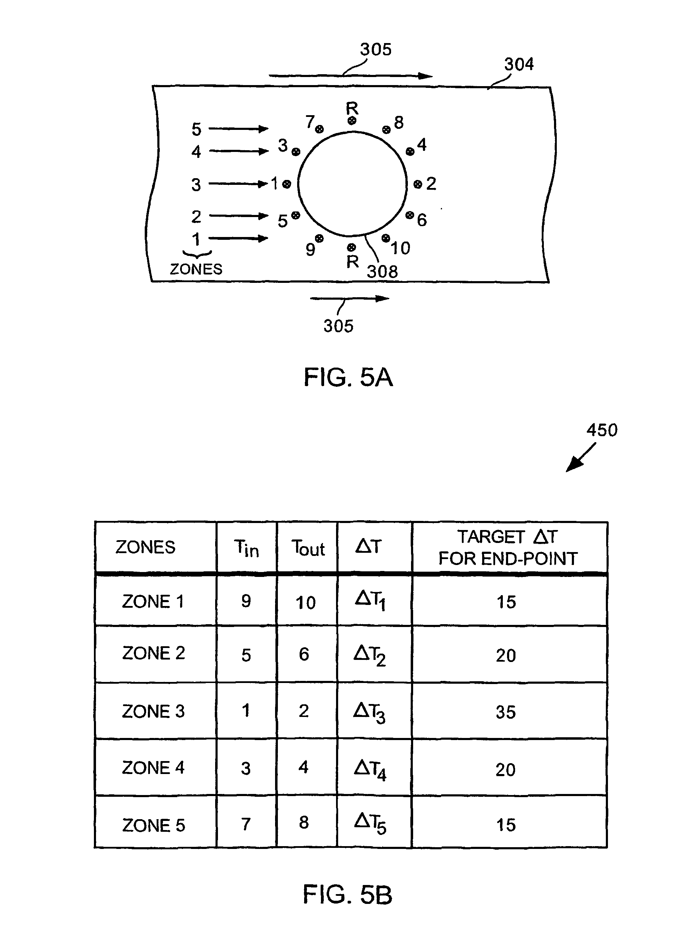

Figure 5A illustrates a top view diagram of another embodiment of the present invention in which a plurality of sensors 1 through 10 and a pair of reference sensors R are arrange around and proximate to the carrier 308. However, it should be understood that any number of pairs of sensors can also be used. In this embodiment, the sensors are divided into five zones over the wafer being polished. As the pad rotates in the direction 305, temperature differentials are determined between sensors 9 and 10, 5 and 6, 1 and 2, 3 and 4, and 7 and 8. Each of these temperature differentials ΔT₁ through ΔT₅ define zones 1 through 5, respectively. For each of these zones, there is a determined target temperature differential for ascertaining end-point.

By calibrated tests, it may be determined that target temperature differentials for each zone may vary as shown in Figure 5B. For instance, zones 1 and 5 may have a target temperature differential of 15, zones 2 and 4 may have a temperature differential target about 20, and zone 3 may have a temperature differential of about 35. By examining the temperature differentials in each of the zones, it is possible to ascertain whether the proper end-point has been reach for the different zones of the wafer being polished in Figure 5A. Accordingly, the embodiments of Figures 3 through 4 are equally applicable to the embodiment of Figures 5A and 5B. However, by analyzing different zones of the wafer surface, it is possible to ascertain more precise end-point over the different zones of a given wafer. Of course, more or less sensors may be implemented depending upon the number of zones desired to be monitored.

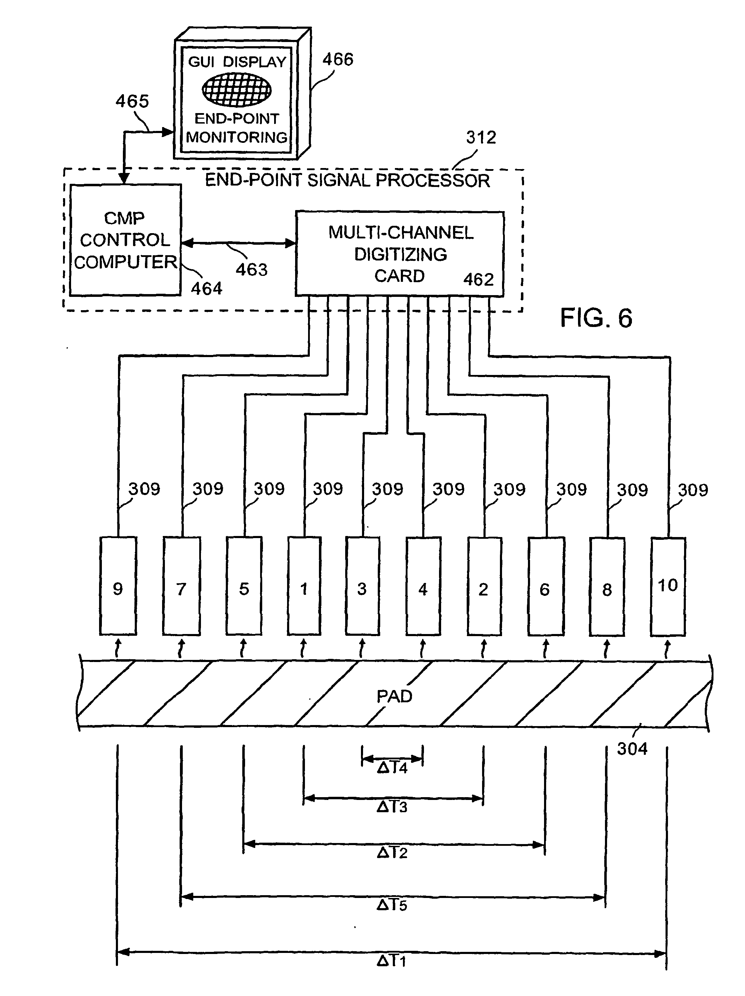

Figure 6 illustrates a schematic diagram of the sensors 1 through 10 shown in Figure 5A. The sensors 1 through 10 (*e.g*., such as sensors 110a and 110b of Figure 30 are arranged in a position that is proximate to the pad but in a stationary position that does not rotate as does the carrier 308. By determining the temperature at the different locations over the pad 304 as a polishing operation is in progress, the temperature differentials ΔT₁ through ΔT₅ can be ascertained at the different relative locations of the pad 304. The sensed signals 309 are then communicated to the end-point signal processor 312.

The end-point signal processor 312 is configured to include a multi-channel digitizing card 462 (or digitizing circuit). Multi-channel digitizing card 462 is configured to sample each of the signals and provide an appropriate output 463 to a CMP control computer 464. The CMP control computer 464 can then process the signals received from the multi-channel digitizing card 462 and provide them over a signal 465 to a graphical display 466. The graphical display 466 may include a graphical user interface (GUI) that will illustrate pictorially the different zones of the wafer being polished and signify when the appropriate end-point has been reached for each particular zone. If the end-point is being reached for one zone before another zone, it may be possible to apply appropriate back pressure to the wafer or change the polishing pad back pressure in those given locations in which polishing is slow in order to improve the uniformity of the CMP operation and thus enable the reaching of an end-point throughout the wafer in a uniform manner (i.e., at about the same time).

As can be appreciated, the end-point monitoring of the present invention has the benefit of allowing more precision CMP operations over a wafer and zeroing on selected regions of the wafer being polished to ascertain whether the desired material has been removed leaving the under surface in a clean, yet unharmed condition. It should also be noted that the monitoring embodiments of the present invention are also configured to be non-destructive to a wafer that may be sensitive to photo-assisted corrosion as described above. Additionally, the embodiments of the present invention do not require that a CMP pad be altered by pad slots or the need to drill slots into a platen or a rotary table that is positioned beneath a pad. Thus, the monitoring is more of a passive monitoring that does not interfere with the precision polishing of a wafer, yet provides very precise indications of end-point to precisely discontinue polishing.

While this invention has been described in terms of several preferred embodiments, it will be appreciated that those skilled in the art upon reading the preceding specification and studying the drawings will realize various alterations, additions, permutations and equivalents thereof. For example, the end-point detection techniques will work for any polishing platform (e.g. belt, table, rotary, orbital, etc.) and for any size wafer or substrate, such as, 200 mm, 300 mm, and larger, as well as other sizes and shapes. It is therefore intended that the present invention includes all such alterations, additions, permutations, and equivalents that fall within the scope of the invention as defined by the claims.

## Claims

1. A chemical mechanical polishing system (300), comprising:
a polishing pad (304) configured to move linearly from a first point to a second point;
a carrier (308) being configured to hold a substrate (301) to be polished over the polishing pad, the carrier being designed to apply the substrate to the polishing pad in a polish location that is between the first point and the second point;
**characterized by:**
a first sensor (310a) located at the first point and oriented so as to sense an IN temperature of the polishing pad;
a second sensor (310b) located at the second point and oriented so as to sense an OUT temperature of the polishing pad;
wherein a temperature differential between the OUT temperature and the IN temperature is monitored during polishing of the substrate, and a change in temperature differential indicates a change in material being polished from the substrate.

2. A chemical mechanical polishing system as claimed in claim 1, further comprising:
an end-point signal processor (312), the end point signal processor being configured to receive sensing signals (309a, 309b) from each of the first and second sensors.

3. A chemical mechanical polishing system as claimed in claim 2, wherein the received signals are processed to monitor a temperature differential between the OUT temperature and the IN temperature during polishing of the substrate.

4. A chemical mechanical polishing system as claimed in claim 2, wherein a change in the temperature differential signals a change in material being polished from the substrate.

5. A chemical mechanical polishing system as daimed in claim 1, wherein the first and second sensors are each infrared sensors.

6. A chemical mechanical polishing system as claimed in claim 1, wherein the first and second sensors are arranged at a separation distance of between about 1 mm and about 250 mm from the polishing pad.

7. A chemical mechanical polishing system as claimed in claim 2, wherein the end-point signal processor further comprises:
a multi-channel digitizing circuit, the multi-channel digitizing circuit (462) being configured to process the sensing signals from the first and second sensors.

8. A chemical mechanical polishing system as claimed in claim 7, further comprising:
a graphical user interface (GUI) display being connected to the end-point processor, the GUI display being configured to illustrate end-point monitoring conditions.

9. A chemical mechanical polishing system as claimed in claim 1, further comprising:
an array of sensor pairs, the array of sensor pairs including the first sensor and the second sensor, each pair of the array of sensor pairs being arranged so as to sense temperature differentials associated with two or more zones of the substrate that is to be polished.

10. A chemical mechanical polishing system as claimed in claim 1, wherein the substrate is one of a semiconductor wafer and a data storage disk.

11. An end-point detection method comprising:
providing a polishing pad (304);
applying a wafer (301) to the polishing pad at a polishing location so as to remove a first layer of material from the wafer;
**characterized by:**
sensing a first temperature of the polishing pad by a first sensor (310a) at an IN location that is before the polishing location; and
sensing a second temerature of the polishing pad by a second sensor (310b) at an OUT location that is after the polishing location;
calculating a temperature differential between the second temperature and the first temperature; and
monitoring a change in the temperature differential, the change being indicative of a removal of the first layer from the wafer.

12. An end-point detection method as claimed in claim 11, wherein the pad is one of a belt pad, a table pad, a rotary pad, and an orbital pad.

13. An end-point detection method as claimed in claim 11, further comprising:
generating a temperature differential table, the temperature differential table including a plurality of temperature differentials wherein each temperature differential is associated with a material type to be polished from the wafer.

14. An end-point detection method as claimed in claim 11, wherein the change in temperature differential further indicates a change in the removal of the first layer being of first type of material to another layer being of a second type of material.

15. An end-point detection method as claimed in claim 14, wherein the first type of material is a metallization material and the second type of material is a barrier material.

16. An end-point detection method as claimed in claim 14, wherein the first type of material is a diffusion barrier material and the second type of material is an dielectric material.

17. An end-point detection method as claimed in claim 12, wherein the sensing includes infrared temperature sensing.

18. An end-point detection method as claimed in claim 12, further comprising:
sensing a plurality of additional pairs of locations, each of the additional pairs of locations including a first point that is before the polishing location and a second point that is after the polishing location.

19. An end-point detection method as claimed in claim 18, wherein each of the additional pairs of locations are configured to provide end-point detection over an associated plurality of zones of the wafer.

## Patentansprüche

1. Chemisch-mechanisches Poliersystem (300), umfassend:
- ein Polierkissen (304), das so gestaltet ist, dass es sich linear von einem ersten Punkt zu einem zweiten Punkt bewegen kann;
- eine Halterung (308), die so gestaltet ist, dass sie ein zu polierendes Substrat (301) über dem Polierkissen halten kann, wobei die Halterung das Substrat in einem Polierbereich, der sich zwischen dem ersten Punkt und dem zweiten Punkt befindet, mit dem Polierkissen in Kontakt bringen kann;
**gekennzeichnet durch**:
- einen ersten Sensor (310a), der an dem ersten Punkt angeordnet und so ausgerichtet ist, dass er eine IN-Temperatur des Polierkissens erfassen kann;
- einen zweiten Sensor (310b), der an dem zweiten Punkt angeordnet und so ausgerichtet ist, dass er eine OUT-Temperatur des Polierkissens erfassen kann;
- wobei während des Polierens des Substrats ein Temperaturunterschied zwischen der OUT-Temperatur und der IN-Temperatur überwacht wird und eine Änderung des Temperaturunterschieds eine Änderung bei dem vom Substrat herunterzupolierenden Material anzeigt.

2. Chemisch-mechanisches Poliersystem nach Anspruch 1, weiter umfassend:
- einen Endpunkt-Signalprozessor (312), wobei der Endpunkt-Signalprozessor so ausgebildet ist, dass er von dem ersten und dem zweiten Sensor erfasste Signale (309a, 309b) empfängt.

3. Chemisch-mechanisches Poliersystem nach Anspruch 2, bei dem die empfangenen Signale verarbeitet werden, um während des Polierens des Substrats einen Temperaturunterschied zwischen der OUT-Temperatur und der IN-Temperatur zu überwachen.

4. Chemisch-mechanisches Poliersystem nach Anspruch 2, bei dem eine Änderung im Temperaturunterschied eine Änderung im Material anzeigt, das von dem Substrat herunterpoliert wird.

5. Chemisch-mechanisches Poliersystem nach Anspruch 1, bei dem der erste und der zweite Sensor jeweils Infrarotsensoren sind.

6. Chemisch-mechanisches Poliersystem nach Anspruch 1, bei dem der erste und der zweite Sensor in einem Abstand von ungefähr 1 mm bis ungefähr 250 mm zum Polierkissen angeordnet sind.

7. Chemisch-mechanisches Poliersystem nach Anspruch 2, bei dem der Endpunkt-Signalprozessor weiter umfasst:
- eine Mehrkanal-Digitalisierungsschaltung, wobei die Mehrkanal-Digitalisierungsschaltung (462) zur Verarbeitung der erfassten Signale von dem ersten und dem zweiten Sensor ausgebildet ist.

8. Chemisch-mechanisches Poliersystem nach Anspruch 7, weiter umfassend:
- ein Display für eine graphische Benutzeroberfläche (GUI), die mit dem Endpunkt-Signalprozessor verbunden und so ausgebildet ist, dass es die Endpunkt-Überwachungsbedingungen darstellt.

9. Chemisch-mechanisches Poliersystem nach Anspruch 1, weiter umfassend:
- ein Array mit Sensorpaaren, wobei das Array mit Sensorpaaren den ersten Sensor und den zweiten Sensor einschließt und wobei jedes Paar der in dem Array angeordneten Sensoren so angeordnet ist, dass es Temperaturunterschiede, die zwei oder mehr Bereichen des zu polierenden Substrats zugeordnet sind, erfasst.

10. Chemisch-mechanisches Poliersystem nach Anspruch 1, bei dem das Substrat ein Halbleiter-Wafer oder eine Datenspeicherscheibe ist.

11. Verfahren zur Endpunktbestimmung, umfassend:
- Bereitstellen eines Polierkissens (304);
- In-Kontakt-Bringen eines Wafers (301) in einem Polierbereich mit dem Polierkissen, um eine erste Materialschicht von dem Wafer zu entfernen;
**gekennzeichnet durch**:
- Erfassen einer ersten Temperatur des Polierkissens an einer IN-Position, die sich vor dem Polierbereich befindet, **durch** einen ersten Sensor (310a); und
- Erfassen einer zweiten Temperatur des Polierkissens an einer OUT-Position, die sich hinter dem Polierbereich befindet, **durch** einen zweiten Sensor (310b);
- Berechnen eines Temperaturunterschiedes zwischen der zweiten Temperatur und der ersten Temperatur, und
- Überwachen einer Änderung des Temperaturunterschiedes, wobei die Änderung einen Hinweis auf die Entfernung der ersten Schicht von dem Wafer darstellt.

12. Verfahren zur Endpunktbestimmung nach Anspruch 11, bei dem es sich bei dem Kissen um ein bandförmiges Kissen, ein plattenförmiges Kissen, ein rotierendes Kissen oder ein umlaufendes Kissen handelt.

13. Verfahren zur Endpunktbestimmung nach Anspruch 11, weiter umfassend:
- Erzeugen einer Tabelle für den Temperaturunterschied, wobei die Tabelle für den Temperaturunterschied mehrere Temperaturunterschiede umfasst und wobei jeder Temperaturunterschied einem Typ von Material zugeordnet ist, das von dem Wafer herunterpoliert werden soll.

14. Verfahren zur Endpunktbestimmung nach Anspruch 11, bei dem die Änderung des Temperaturunterschiedes ferner eine Änderung bei der Entfernung der ersten Schicht, die aus dem ersten Materialtyp besteht, zur Entfernung einer anderen Schicht, die aus einem zweiten Materialtyp besteht, anzeigt.

15. Verfahren zur Endpunktbestimmung nach Anspruch 14, bei dem der erste Materialtyp ein Metallisierungsmaterial und der zweite Materialtyp ein Sperrschichtmaterial ist.

16. Verfahren zur Endpunktbestimmung nach Anspruch 14, bei dem der erste Materialtyp ein Diffusionssperrschichtmaterial und der zweite Materialtyp ein dielektrisches Material ist.

17. Verfahren zur Endpunktbestimmung nach Anspruch 12, bei dem das Erfassen die Erfassung der Temperatur durch Infrarot umfasst.

18. Verfahren zur Endpunktbestimmung nach Anspruch 12, weiter umfassend:
- Erfassen mehrerer weiterer Paare von Positionen, wobei jedes weitere Paar von Positionen einen ersten Punkt, der vor dem Polierbereich liegt, und einen zweiten Punkt, der hinter dem Polierbereich liegt, umfasst.

19. Verfahren zur Endpunktbestimmung nach Anspruch 18, bei dem jedes der zusätzlichen Paare von Positionen zum Bereitstellen einer Endpunktbestimmung für mehrere zugeordnete Bereiche des Wafers ausgebildet ist.

## Revendications

1. Un système (300) de polissage mécano-chimique comprenant :
- un tampon de polissage (304) configuré pour se déplacer de manière linéaire d'un premier point vers un second point ;
- un support (303) configuré pour maintenir un substrat (301) à polir sur le tampon de polissage, le support étant conçu pour appliquer le substrat sur le tampon de polissage à un emplacement à polir qui se situe entre le premier point et le second point ;
**caractérisé par** un premier capteur (310a) situé au niveau du premier point et orienté de façon à détecter une température d'entrée du tampon de polissage ;
un second capteur (310b) situé au niveau du second point et orienté de façon à détecter une température de sortie du tampon de polissage ;
dans lequel un écart de température entre la température de sortie et la température d'entrée est contrôlé pendant le polissage du substrat, et un changement d'écart de température indique que le matériau du substrat en cours de polissage a changé.

2. Un système de polissage mécano-chimique selon la revendication 1, comprenant en outre :
- un processeur (312) de signal de point limite, le processeur de signal de point limite étant configuré pour recevoir des signaux (309a, 309b) de détection de chacun des premiers et seconds capteurs.

3. Un système de polissage mécano-chimique selon la revendication 2, dans lequel les signaux reçus sont traités pour surveiller un écart de température entre la température de sortie et la température d'entrée pendant le polissage du substrat.

4. Un système de polissage mécano-chimique selon la revendication 2, dans lequel un changement dans l'écart de température indique que le matériau du substrat en cours de polissage a changé.

5. Un système de polissage mécano-chimique selon la revendication 1, dans lequel le premier capteur et le second capteur sont chacun des capteurs infrarouges.

6. Un système de polissage mécano-chimique selon la revendication 1, dans lequel le premier capteur et le second capteur sont disposés à une distance de séparation située entre environ 1 mm et environ 250 mm du tampon de polissage.

7. Un système de polissage mécano-chimique selon la revendication 2, dans lequel le processeur de signal de point limite comprend en outre :
- un circuit de numérisation à canaux multiples, le circuit (462) de numérisation à canaux multiples étant configuré pour traiter les signaux de détection provenant du premier capteur et du second capteur.

8. Un système de polissage mécano-chimique selon la revendication 7, comprenant en outre :
- un afficheur d'interface utilisateur graphique (IUG) connecté au processeur de point limite, l'afficheur d'IUG étant configuré pour illustrer les conditions de contrôle de point limite.

9. Un système de polissage mécano-chimique selon la revendication 1, comprenant en outre,
- un réseau de paires de capteurs, le réseau de paires de capteurs comprenant le premier capteur et le second capteur, chaque paire du réseau de paires de capteurs étant disposée de façon à détecter les écarts de température associés à deux ou plusieurs zones du substrat qui doit être poli.

10. Un système de polissage mécano-chimique selon la revendication 1, dans lequel le substrat est un substrat choisi parmi une tranche de semi-conducteur et un disque de stockage de données.

11. Procédé de détection de point limite comprenant les étapes de :
- fournir un tampon (304) de polissage ;
- appliquer une tranche (301) sur le tampon de polissage à un emplacement de polissage de façon à éliminer une première couche de matériau de la tranche ;
**caractérisé par** la détection d'une première température du tampon de polissage par un premier capteur (310a) à un emplacement d'entrée qui est situé avant l'emplacement de polissage ; et
- la détection d'une seconde température du tampon de polissage par un second capteur (310b) à un emplacement de sortie qui est situé après l'emplacement de polissage ;
- calculer un écart de température entre la seconde température et la première température ; et
- surveiller un changement dans l'écart de température, le changement indiquant une élimination de la première couche de la tranche.

12. Procédé de détection de point limite selon la revendication 11, dans lequel le tampon est un tampon choisi parmi un tampon à courroie, un tampon à plateau, un tampon rotatif, et un tampon orbital.

13. Procédé de détection de point limite selon la revendication 11, comprenant en outre l'étape de :
- générer un tableau d'écart de température, le tableau d'écart de température comprenant une pluralité d'écarts de température dans lequel chaque écart de température est associé à un type de matériau à polir de la tranche.

14. Procédé de détection de point limite selon la revendication 11, dans lequel le changement dans l'écart de température indique en outre un changement dans l'élimination de la première couche qui est d'un premier type de matériau à une autre couche qui est d'un second type de matériau.

15. Procédé de détection de point limite selon la revendication 14, dans lequel le premier type de matériau est un matériau de métallisation et le second type de matériau est un matériau barrière.

16. Procédé de détection de point limite selon la revendication 14, dans lequel le premier type de matériau est un matériau de barrière de diffusion et le second type de matériau est un matériau diélectrique.

17. Procédé de détection de point limite selon la revendication 12, dans lequel la détection comprend la détection de la température infrarouge.

18. Procédé de détection de point limite selon la revendication 12, comprenant en outre l'étape de :
- détecter une pluralité de paires supplémentaires d'emplacements, chacune des paires supplémentaires d'emplacements comprenant un premier point qui se situe avant l'emplacement de polissage et un second point qui se situe après l'emplacement de polissage.

19. Procédé de détection de point limite selon la revendication 18, dans lequel chacune des paires supplémentaires d'emplacements est configurée pour fournir une détection de point limite sur une pluralité associée de zones de la tranche.
